Europäisches Patentamt

European Patent Office

Office européen des brevets

(19)

(11) **EP 1 335 490 A2**

(12) ## EUROPEAN PATENT APPLICATION

(43) Date of publication:
**13.08.2003 Bulletin 2003/33**

(51) Int Cl.$^7$: **H03G 3/30**

(21) Application number: **02020541.5**

(22) Date of filing: **16.09.2002**

(84) Designated Contracting States:
**AT BE BG CH CY CZ DE DK EE ES FI FR GB GR
IE IT LI LU MC NL PT SE SK TR**
Designated Extension States:
**AL LT LV MK RO SI**

(30) Priority: **12.02.2002 JP 2002033443**

(71) Applicant: **Pioneer Corporation
Meguro-ku, Tokyo (JP)**

(72) Inventor: **Hoshino, Hironobu,
Pioneer Corporation Kawagoe Wks
Kawagoe-shi, Saitama (JP)**

(74) Representative:
**Manitz, Finsterwald & Partner GbR
Postfach 31 02 20
80102 München (DE)**

(54) **Receiving apparatus with an AGC function**

(57)     An RF-amplifier circuit and an IF-amplifier circuit are provided with each having a gain that can be freely adjusted, and when synchronization with a reception signal from a digital broadcast is not established though the level of the reception signal is high enough, the gain of the RF-amplifier circuit is decreased and the gain of the IF-amplifier circuit is increased, whereby the level of the reception signal is maintained constant and a stronger input caused by a radio wave from an analog broadcast is reduced.

EP 1 335 490 A2

**Description**

BACKGROUND OF THE INVENTION

1. Field of the Invention

The present invention relates to a broadcast receiving apparatus having an automatic gain control (hereinafter referred to as a AGC) function.

2. Description of the Related Art

Integrated Services Digital Broadcasting-Terrestrial (hereinafter referred to as ISDB-T) is a type of terrestrial broadcast service based on a digital-signal method. ISDB-T collectively handles various types of component signals such as image, sound, character, data, and so forth, which are used for general broadcast services, and integrates the various types of component signals into a digital-broadcast radio wave for broadcasting. The radio waveband of ISDB-T is the same as that of an analog TV broadcast, such as a VHF radio waveband, or a UHF radio waveband. Therefore, during the transition from the analog TV broadcast to ISDB-T, the radio waves of the broadcasts co-exist and are mixed in the same radio waveband.

When a receiving apparatus for a digital broadcast such as ISDB-T or the like (hereinafter referred to as a receiving apparatus) selects a predetermined station for the digital broadcast, the following processing is performed.

First, the receiving apparatus converts a received radio frequency signal (hereinafter referred to as an RF signal) into a predetermined intermediate frequency signal (hereinafter referred to as an IF signal), and performs an analog/digital conversion (hereinafter referred to as an A/D conversion) of the IF signal. Then, the receiving apparatus tries to establish synchronization with the digital signal obtained by the A/D conversion, detects whether or not the digital broadcast exists corresponding to the result of the synchronization, and selects a suitable station. When the synchronization is not established even though the level of the received signal is higher than a predetermined level, the receiving apparatus determines that the digital broadcast does not exist in the current radio waveband.

However, the electrical power of the analog broadcast radio wave is concentrated in the waveband for a carrier wave for an image signal or a sound signal. Therefore, in a specific radio waveband, the reception level of a radio wave from the analog broadcast is often relatively higher than that from the digital broadcast. Accordingly, when the radio wave from the analog broadcast exists near the radio wave from the digital broadcast, and the gain of an RF-amplifier circuit of the receiving apparatus is adjusted according to the reception level of the radio wave from the digital broadcast, the reception signal from the analog broadcast has a stronger input. The stronger input causes an intermodulation distortion in the RF-amplifier circuit, and a cross-modulation distortion in a mixer for converting frequencies, the mixer being connected to the subsequent stage of the RF-amplifier circuit. The above-described distortion interferes with the reception signal from the digital broadcast. Therefore, it becomes difficult to establish the synchronization. In such a case, the receiving apparatus determines that the digital broadcast does not exist in the current radio waveband.

Hitherto, for avoiding such a mistaken determination, a signal-strength meter circuit for detecting whether or not a stronger input signal exists is provided in an output unit of the RF-amplifier circuit, for example. By using the signal-strength meter circuit, the gain of the RF-amplifier circuit is controlled. However, according to this method, the circuit configuration of the receiving apparatus becomes complicated, and the cost is increased. Further, since the gain of the RF-amplifier circuit is adjusted corresponding to the stronger input signal of the analog broadcast, the signal-to-noise ratio in the digital broadcast is reduced, and the reception of the digital broadcast is interfered with.

OBJECTS AND SUMMARY OF THE INVENTION

Accordingly, it is an object of the present invention to provide a receiving apparatus for reliably selecting a station for the digital broadcast, when the radio waveband for the analog broadcast and the radio waveband for the digital broadcast are close together and mixed.

A receiving apparatus with an AGC function according to a first aspect of the present invention comprises an RF-signal amplifying unit for amplifying a received RF signal corresponding to the gain thereof adjusted by a first control signal, and an IF-signal amplifying unit for amplifying an IF signal that is obtained by converting the output from the RF-signal amplifying unit corresponding to the gain thereof adjusted by a second control signal. The receiving apparatus with an AGC function further comprises a level-detection unit for generating a level-detection signal by detecting the level of an output signal from the IF-signal amplifying unit, and a reception-state determination unit. The reception-state determination unit demodulates the output signal from the IF-amplifying unit, determines the reception state of the RF-signal corresponding to the demodulation result, and generates a fine-reception signal when the reception state satisfies a predetermined requirement. The receiving apparatus with an AGC function further comprises a gain-control unit for generating the first and second control signals corresponding to the level-detection signal and the fine-reception signal. When the fine-reception signal is not generated though the level of the output signal indicates that the fine-reception state can be maintained, the gain-control unit performs gain-adjusting control by decreasing the gain of the RF-signal amplifying unit and increasing the gain of the IF-signal amplifying unit.

Preferably, the reception-state determination unit detects that synchronization is established when the output signal is demodulated, generates a detection signal indicating that the synchronization is established, and uses the detection signal as the fine-reception signal.

Preferably, the gain-control unit maintains the level of the output signal constant and performs the gain-adjusting control.

The receiving apparatus with an AGC function may further comprise a station-selection-mode setting unit. The station-selection-mode setting unit may freely set the station-selection mode for frequency bands each covering a divided portion of the reception band for the RF signal. The reception band may be divided according to a setting command. The gain-control unit may or may not perform the gain-adjusting control corresponding to the current station-selection mode.

BRIEF DESCRIPTION OF THE DRAWINGS

Fig. 1 is a block diagram schematically illustrating a receiving apparatus with an AGC function according to a first embodiment of the present invention;
Fig. 2 is a flowchart illustrating the operation of the receiving apparatus with an AGC function shown in Fig. 1;
Fig. 3 is a level diagram for illustrating a front-end unit of the receiving apparatus with an AGC function shown in Fig. 1; and
Fig. 4 is a flowchart illustrating the operation of the receiving apparatus with an AGC function according to a second embodiment of the present invention.

DETAILED DESCRIPTION OF THE PREFERRED EMBODIMENTS

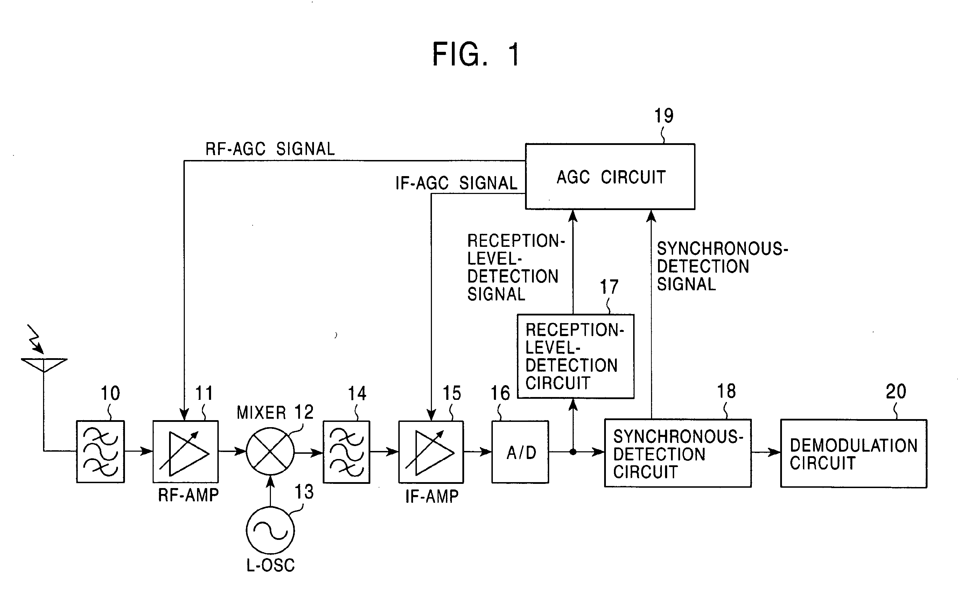

Fig. 1 is a block diagram illustrating a receiving apparatus with an AGC function (hereinafter referred to as a receiving apparatus) according to a first embodiment of the present invention.

The construction of the receiving apparatus is described by referring to the drawing. The receiving apparatus comprises an antenna, a radio-frequency bandpass filter 10 (hereinafter referred to as an RF-bandpass filter 10), a radio-frequency amplifier circuit 11 (hereinafter referred to as an RF-amplifier circuit 11), a mixer 12, a local-oscillation circuit 13, an intermediate-frequency bandpass filter 14 (hereinafter referred to as an IF-bandpass filter 14), an intermediate-frequency amplifier circuit 15 (hereinafter referred to as an IF-amplifier circuit 15), an analog/digital converter 16 (hereinafter referred to as an A/D converter 16), a reception-level-detection circuit 17, a synchronous-detection circuit 18, an AGC circuit 19, and a demodulation circuit 20. The RF-bandpass filter 10 extracts an RF signal of a predetermined channel from the radio waveband of a digital broadcast.

The RF-amplifier circuit 11 amplifies the RF signal extracted by the RF-bandpass filter 10 to a predetermined level. The gain of the RF-amplifier circuit 11 can be freely adjusted by a radio-frequency-amplifier-circuit gain-control signal (hereinafter referred to as an RF-AGC signal), which will be described later.

The mixer 12 is a frequency-mixer circuit using a diode or the like, for example. The mixer 12 multiplies an output signal from the RF-amplifier circuit 11 and a signal from the local-oscillation circuit 13. Subsequently, an IF signal that is output from the mixer 12 has a frequency that is the sum of an integral multiple of the output signal from the RF-amplifier circuit 11 and an integral multiple of the signal from the local-oscillation circuit 13. Otherwise, the IF signal that is output from the mixer 12 has a frequency that is the difference between the integral multiple of the output signal from the RF-amplifier circuit 11 and the integral multiple of the signal from the local-oscillation circuit 13. That is to say, the mixer 12 converts the received RF signal into an IF signal.

The IF-bandpass filter 14 removes an unnecessary wave from such the IF signal. The IF-amplifier circuit 15 amplifies the IF signal, which is transmitted from the IF-bandpass filter 14, to a predetermined level. The gain of the IF-amplifier circuit 15 is freely adjusted by an intermediate-frequency-amplifier-circuit gain-control signal (hereinafter referred to as an IF-AGC signal), which will be described later.

The A/D converter 16 converts the output signal from the IF-amplifier circuit 15 into a digital signal having a predetermined bit-length such as 12-bits, 16-bits, and so forth by using a predetermined sampling frequency.

The synchronous-detection circuit 18 performs synchronization of a reception signal, which is necessary for demodulating and reproducing received information of the digital broadcast. When synchronization with the reception signal is established, the synchronous-detection circuit 18 outputs a synchronous-detection signal to the AGC circuit 19 for notifying it that the synchronization is established.

The digital signal from the synchronous-detection circuit 18 is transmitted to the demodulation circuit 20 and is subjected to correction processing and demodulation/reproducing processing such as deinterleave processing. Subsequently, the information received from the digital broadcast is reproduced.

The output from the A/D converter 16 is transmitted to the synchronous-detection circuit 18 and is also transmitted to the reception-level detection circuit 17. The reception-level detection circuit 17 detects the absolute value of the level of the IF signal that is input to the A/D converter 16 from the information in the digital signal from the A/D converter 16. The value detected by the reception-level detection circuit 17 is output to the AGC circuit 19 as a reception-level-detection signal.

The AGC circuit 19 comprises a microprocessor (hereinafter referred to as a µCPU) and a memory circuit such as a ROM or a RAM with the peripheral circuits thereof, which are not shown in the drawing. The AGC circuit 19 generates the RF-AGC signal and the IF-AGC signal corresponding to the above-described synchronous-detection signal and the reception-level-detection signal. The RF-AGC signal is transmitted to the RF-amplifier circuit 11, and the IF-AGC signal is transmitted to the IF-amplifier circuit 15.

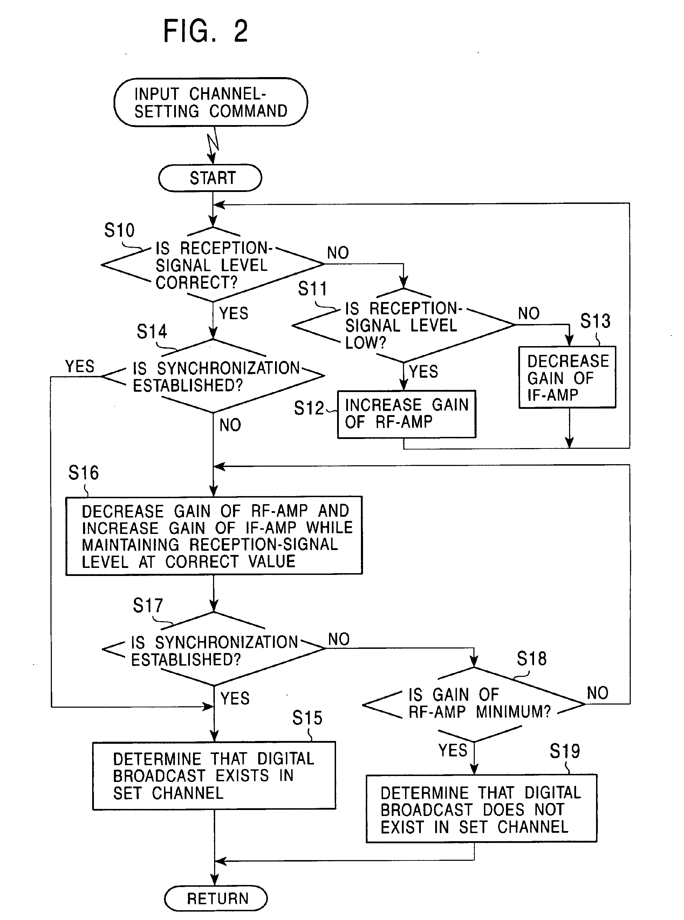

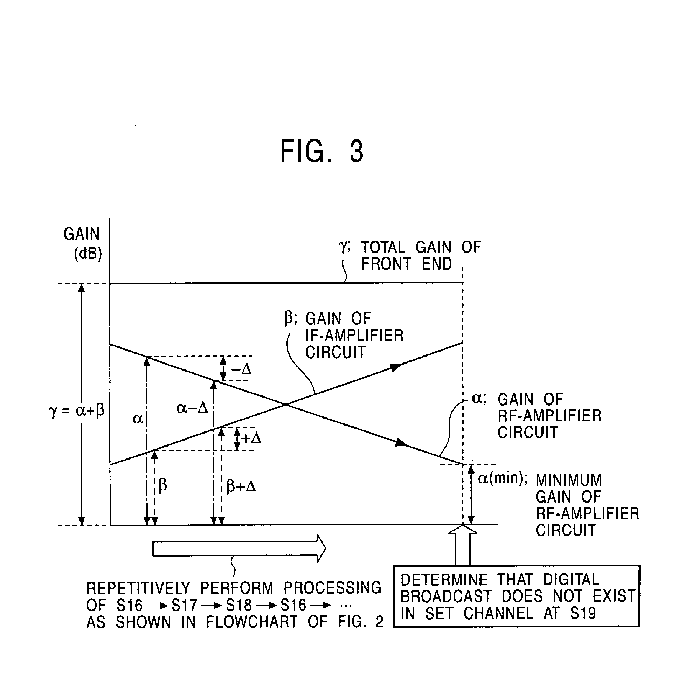

Next, the operation of the receiving apparatus shown in Fig. 1 will now be described with reference to Fig. 2, which is a flowchart illustrating a sub-routine program of the AGC circuit 19.

The sub-routine program is installed in, for example, the memory circuit such as the ROM in the AGC circuit 19 as one part of the main-routine program that controls the receiving apparatus. When the sub-routine program is started, the µCPU in the AGC circuit 19 runs the sub-routine program step by step in synchronization with an internal clock that is provided in the µCPU.

The sub-routine program is started when a user inputs a setting command for receiving a predetermined channel of the digital broadcast by using, for example, a control panel (not shown) of the receiving apparatus. When such a setting command is issued, the central frequency of the bandpass filters shown in Fig. 1, the oscillation frequency from the local-oscillation circuit 13, and so forth are set to a predetermined value so as to extract a signal from the frequency band wherein the predetermined channel of the digital broadcast is included.

When the sub-routine program shown in Fig. 2 is started, the µCPU in the AGC circuit 19 (hereinafter referred to as a control CPU) determines whether or not the level of the reception signal is within the range of a predetermined correct value at step S10. The level of the reception signal indicates the absolute value of the IF signal that is input to the A/D converter 16. Further, the predetermined correct value denotes the magnitude of the reception signal, which is appropriate for the receiving apparatus so that the receiving apparatus can keep receiving the broadcast satisfactory. Such determination is performed corresponding to the reception-level-detection signal that is output from the reception-level-detection circuit 17.

When the value of the reception-signal level is determined as incorrect, the control CPU proceeds to step S11 and determines whether or not the value of the reception-signal level is less than the predetermined correct value. When it is determined that the reception level is less than the predetermined correct value at step S11, the amplified gain of the signal that is currently being received is insufficient. Therefore, the control CPU generates the RF-AGC signal for increasing the gain of the RF-amplifier circuit 11, and transmits the RF-AGC signal to the RF-amplifier circuit 11 at step S12. Then, the control CPU goes back to step S10 for monitoring and determining the level of the reception signal again.

On the other hand, when it is determined that the reception level is greater than the correct value at step S11, the control CPU proceeds to step S13 and generates the IF-AGC signal for decreasing the gain of the IF-amplifier circuit 15. Then, the control CPU transmits the IF-AGC signal to the IF-amplifier circuit 15. As described above, the gain of the IF-amplifier circuit 15 is decreased, not the gain of the RF-amplifier circuit 11, because the electric field strength of the reception radio wave is generally weak. Accordingly, it is better to maintain the gain of the RF-amplifier circuit 11 even when the level of the reception signal is decreased. After completing the processing at step S13, the control CPU goes back to step S10 and performs monitoring and determining of the level of the reception signal again.

By repetitively performing the processing of steps S11→S12→S10, or the processing of steps S11→S13→S10, the level of the reception signal gradually approaches the correct value.

When it is determined that the reception-signal level is correct, the control CPU proceeds to step S14 to check the synchronous-detection signal that was transmitted from the synchronous-detection circuit 18 and to determine whether or not synchronization with the reception signal is established or not.

When the synchronization with the reception signal is detected at step S14, the control CPU determines that the digital broadcast exists in the channel for which the user issued the setting command (step S15). Then, the control CPU notifies the main-routine program (not shown), which controls the receiving apparatus, of the determined result, and terminates the processing of the sub-routine program shown in Fig. 2.

On the other hand, when the synchronization with the reception signal is not detected at step S14, the control CPU proceeds to step S16.

When there is a strong radio wave of an analog broadcast near the radio wave of the predetermined digital broadcast channel, an input signal from the radio wave of the analog broadcast becomes a stronger input for the receiving apparatus, and interferes with the reception signal of the digital broadcast. That is to say, the synchronization with the reception signal may not be established because of the stronger input signal from the radio wave of the analog broadcast, though the level of the reception signal is correct at steps S10 and S14.

Subsequently, the control CPU decreases the gain of the RF-amplifier circuit 11 so as to reduce the effect caused by the stronger input signal at step S16. More specifically, the control CPU generates the RF-AGC signal for decreasing the gain of the RF-amplifier circuit 11, and transmits the RF-AGC signal to the RF-amplifier circuit 11. Accordingly, the gain of the RF-amplifier circuit 11 is decreased. Therefore, the effect of the stronger input from the radio wave of the analog broadcast can be decreased.

However, when the gain of the RF-amplifier circuit 11 is decreased, the level of the output signal from the IF-amplifier circuit 15 is also decreased. Therefore, the level of the reception signal, which indicates the absolute value of the input signal to the A/D converter 16, may become less than the predetermined correct value. For solving such a problem, the control CPU reduces the gain of the RF-amplifier circuit 11 and increases the gain of the IF-amplifier circuit 15 at step S16, so that the level of the reception signal is maintained as high as the predetermined correct value. Such control processing will now be described with reference to Fig. 3, which is the level diagram illustrating the amplified gain.

In the drawing, a reference character $\alpha$(dB) indicates the gain of the RF-amplifier circuit 11, and a reference character $\beta$(dB) indicates the gain of the IF-amplifier circuit 15. A reference character $\gamma$(dB) indicates the total gain of the RF-amplifier unit and the IF-amplifier unit, which are sometimes referred to as the front-end unit of the receiving apparatus. The total gain $\gamma$(dB) can be expressed by the expression;

$$\gamma(dB) = \alpha(dB) + \beta(dB).$$

Thus, the control CPU decreases the gain of the RF-amplifier circuit 11 by $\Delta$(dB), and increases the gain of the IF-amplifier circuit 15 by $\Delta$(dB), thereby keeping the total gain $\gamma$(dB) constant as shown by the following expression.

$$\gamma(dB) = (\alpha-\Delta)(dB) + (\beta+\Delta)(dB)$$
$$= \alpha(dB) + \beta(dB)$$

Since the front-end unit comprises a frequency converter or various types of filter circuits, it is rather difficult, to express the total gain $\gamma$(dB) by such a simple expression. However, for describing the operation principles according to the embodiment, the total gain $\gamma$(dB) is expressed by using such a simplified expression.

Then, the control CPU proceeds to step S17, checks the synchronous-detection signal that is transmitted from the synchronous-detection circuit 18, and determines whether or not the synchronization with the reception signal is established. When the synchronization is detected, the control CPU determines that the digital broadcast exists in the channel, the channel being set by the user, at step S15. The control CPU notifies the main-routine program of the determined result and terminates the processing for the sub-routine program shown in Fig. 2.

On the other hand, when the synchronization is not detected at step S17, the control CPU proceeds to step S18 for determining whether or not the gain of the RF-amplifier circuit 11 is reduced to the minimum value $\alpha$[min](dB). If the gain does not reach the minimum value, the control CPU goes back to step S16 for adjusting the gain of the RF-amplifier circuit 11 and that of the IF-amplifier circuit 15, and checking whether or not the synchronization with the reception signal is established at step S17.

By repeating such processing, the gain of the RF-amplifier circuit 11 is reduced to the minimum value $\alpha$[min](dB). The control CPU proceeds to step S19, and determines that the digital broadcast that can be received does not exist in the channel that had been set by the user. Then, the control CPU notifies the main-routine program of the determined result, and terminates the processing for the sub-routine program shown in Fig. 2.

Thus, according to the above-described embodiment, the synchronization with the reception signal can be established by reducing the gain of the RF-amplifier unit of the receiving apparatus even in the case where the stronger input from the analog broadcast affects though the reception level is correct.

Once the synchronization is established, the reception signal can be reproduced with relative ease by using a signal such as TMCC (Transmission and Multiplexing Configuration Control) information, which is included in an AC carrier of the ISDB-T.

Further, when the synchronization is established by performing the gain-adjusting processing at step S16 and at the following steps, it becomes possible to notify the user of the existence of the digital broadcast in the channel set by the user, and of the fact that the strength of the radio wave of the digital broadcast is relatively low. Accordingly, the user can move to a place where he/she can receive the reception signal better corresponding to such information.

This embodiment describes how to receive the digital broadcast regardless of the analog broadcast, which is adjacent thereto, in a radio waveband wherein the analog-broadcast radio wave having a high signal level and the digital-broadcast radio wave having a low signal level co-exist and are mixed. However, this embodiment is not limited to such an example. For example, radio waves of broadcasts of the same type can interfere with the reception of the broadcast each other when they are adjacent. Further, radio waves from different analog broadcasts, or radio waves from different digital broadcasts can interfere with the reception of the broadcast of each other. Therefore, the embodiment can be applied for avoiding the interference of the reception of an analog broadcast caused by a digital broadcast that is adjacent thereto, the interference of the reception of a digital broadcast caused by an analog broadcast that is adjacent thereto, or the interference of the reception of a digital broadcast caused by another digital broadcast that is adjacent thereto.

Further, in this embodiment, the effect caused by intermodulation distortion or cross-modulation distortion is reduced by adjusting the gain of the RF-amplifier circuit 11 and that of the IF-amplifier circuit 15, and by keeping the level of the reception signal from the radio wave of the predetermined broadcast constant. Subsequently, the synchronization with the reception signal can be established. However, when there are two radio waves that interfere with the reception of the radio wave of a predetermined broadcast, the intermodulation distortion increases by 3 dB when the signal level increases by 1 dB. Accordingly, when the synchronization with the reception signal cannot be established by performing the gain-adjusting processing according to the embodiment, the level of the reception signal may be reduced. That is to say, the gain of the RF-amplifier circuit 11 may further be reduced so as to continue the gain-adjusting processing.

Next, a second embodiment of the present invention will be described. The second embodiment defines a frequency band for which the gain-adjusting processing, which was performed at step S16 and at the following steps as shown in Fig. 2, is performed, and another frequency band for which the gain-adjusting processing is not performed.

In a real-life situation, the receiving apparatus of the present invention might be operated in an area wherein no digital broadcasts are provided because of regional or time conditions. The receiving apparatus according to the first embodiment performs the above-described gain-adjusting processing even when it is operated in such an area wherein no digital broadcasts are provided. In such a case, when the user issues a so-called seek-command for detecting a digital broadcast over a plurality of channels to the receiving apparatus, the time required for the processing is increased. The second embodiment is provided for solving such a problem.

In the second embodiment, the frequency band for reception of the receiving apparatus is divided in a plurality of frequency bands. The divided frequency bands are each provided with a "gain-adjusting-processing flag" for determining whether or not the gain-adjusting processing, which is performed at step S16 and at the following steps, is performed. When the flag is ON, the gain-adjusting processing is performed. When the flag is OFF, the gain-adjusting processing is not performed. Such flags may be provided in, for example, a nonvolatile RAM area in the memory circuits included in the AGC circuit 19, or on another writable recording medium.

Further, this embodiment is based on the premise that such flags must be set in advance. That is to say, the divided frequency bands are each set whether or not they require the gain-adjusting processing.

When the frequency band requires the gain-adjusting processing, the flag thereof is set to ON. Otherwise, the flag is set to OFF. Such setting may be performed by the user by using a keyboard (not shown) or the like on the control panel of the receiving apparatus. Further, it may be arranged that the flag data for each region, which is recorded on a portable recording medium such as a memory stick, is read from a data-reading unit (not shown) of the receiving apparatus into the memory circuit in the AGC circuit 19.

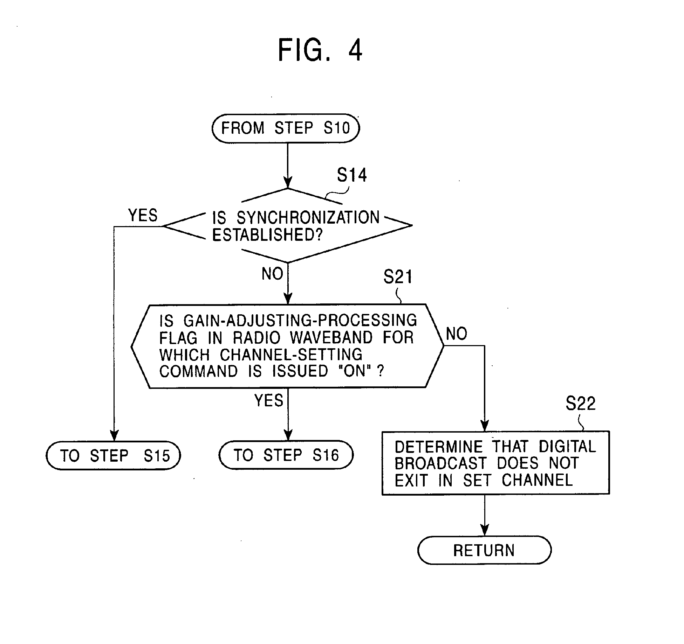

The configuration of a receiving apparatus according to this embodiment, and the sub-routine program thereof are substantially the same as in the case of the first embodiment shown in Figs. 1 and 2. Therefore, only the part of the sub-routine program, which is different from that of the previous embodiment, is illustrated in the flowchart shown in Fig. 4.

The processing performed in the receiving apparatus according to this embodiment is partly different from that of the first embodiment. That is to say, the processing performed from step S10 to step S14 shown in Fig. 2 are also performed in the receiving apparatus of this embodiment. Further, when the synchronization is detected in the synchronous-detection circuit 18, the control CPU in the AGC circuit 19 proceeds to step S15, and terminates the processing shown in Fig. 4.

In this embodiment, however, when the synchronization is not detected at step S14, the control CPU proceeds to step S21, retrieves and checks the gain-adjusting-processing flag for the frequency band for which a channel-setting command was issued, that is, the current frequency band in the memory area. When the flag is ON, the control CPU proceeds to step S16, and performs the same processing as that performed at step S17 and at the following steps, as illustrated in Fig. 2. That is to say, the gain-adjusting processing for the RF-amplifier circuit 11 and the IF-amplifier circuit 15 is performed for checking whether or not the digital broadcast exists in the frequency band of concern as in the first embodiment.

On the other hand, when the gain-adjusting processing flag is OFF at step S21, the control CPU proceeds to step S22. In such a case, the control CPU does not perform the gain-adjusting processing for the frequency band for which the channel-setting command was issued, and determines that no digital broadcasts that can be received exist in the channel concerned. Then, the control CPU terminates the sub-routine program illustrated in Fig. 4.

Thus, the receiving apparatus can eliminate the need for performing the gain-adjusting processing in a frequency band wherein no digital broadcasts exist. Therefore, the receiving apparatus is capable of performing seek processing at high speed.

As has been described, the present invention allows for demodulating and reproducing a signal from a digital broadcast when the frequency band for an analog broadcast and the frequency band for the digital broadcast are close to each other and mixed.

It is understood that the forgoing description and accompanying drawings set forth the preferred embodiments of the invention at the present time. Various modification, additions and alternative designs will, of course, become apparent to those skilled in the art in light of the forgoing teachings without departing from the spirit and scope of the disclosed invention. Thus, it should be appreciated that the invention is not limited to the disclosed embodiments but may be practiced within the full scope of the appended claims.

**Claims**

1. A receiving apparatus with an AGC function comprising:

    an RF-signal amplifying unit for amplifying a received RF signal in accordance with a gain thereof adjusted by a first control signal;
    an IF-signal amplifying unit for amplifying an IF signal, that is obtained by frequency-converting an output of the RF-signal amplifying unit, in accordance with a gain thereof adjusted by a second control signal;
    a level detection unit for detecting a signal level of an output signal of the IF-signal amplifying unit to generate a level detection signal;
    a reception state determination unit for demodulating the output signal of the IF-signal amplifying unit, to determine a reception state of the RF-signal on the basis of a demodulation result, and generate a fine reception signal when the reception state satisfies a predetermined requirement; and
    a gain control unit for generating the first and second control signals on the basis of the level detection signal and the fine reception signal,

    wherein when the fine reception signal is not generated though the signal level of the output signal is sufficient to ensure generation of the fine reception signal, the gain control unit performs gain-adjusting control by decreasing the gain of the RF-signal amplifying unit and increasing the gain of the IF-signal amplifying unit.

2. The receiving apparatus with an AGC function according to Claim 1, wherein the reception state determination unit detects whether synchronization is established when the reception state determination unit demodulates the output signal of the IF-signal amplifying unit, generates a detection signal indicating that the synchronization is established when the reception state determination unit detects establishment of synchronization, and uses the detection signal as the fine reception signal.

3. The receiving apparatus with an AGC function according to Claim 1, wherein the gain control unit maintains the signal level of the output signal to be constant while performing the gain-adjusting control.

4. The receiving apparatus with an AGC function according to Claim 1 further including a station selection mode setting unit, which can set station selection modes for frequency bands each covering a divided portion of a reception band for the RF signal, the reception band being divided in accordance with a setting command,
    wherein the gain control unit performs or does not perform the gain-adjusting control on the basis of a current station selection mode.

5. A method for an auto gain control comprising:

    a first amplifying step for amplifying a received RF signal in accordance with a first gain;
    a frequency-converting step for frequency-converting a first amplified signal amplified by the first amplifying step;
    a second amplifying step for amplifying an IF signal, which is obtained by the frequency-converting step, in accordance with a second gain;
    a level detection step for detecting a signal level of a second amplified signal amplified by the second amplifying step;
    a state determination step for generating a fine signal when a reception state on a basis of the second amplified signal satisfies a predetermined requirement; and
    a gain control step for decreasing the first gain and increasing the second gain when the fine signal is not generated though the signal level of the second amplified signal is higher than a predetermined level.

## FIG. 1

RF-AGC SIGNAL

IF-AGC SIGNAL

19 — AGC CIRCUIT

RECEPTION-LEVEL-DETECTION SIGNAL

SYNCHRONOUS-DETECTION SIGNAL

17 — RECEPTION-LEVEL-DETECTION CIRCUIT

18 — SYNCHRONOUS-DETECTION CIRCUIT

20 — DEMODULATION CIRCUIT

16 — A/D

15 — IF-AMP

14

11 — RF-AMP

MIXER 12

13 — L-OSC

10

# FIG. 2

INPUT CHANNEL-
SETTING COMMAND

START

S10 — IS RECEPTION-
SIGNAL LEVEL
CORRECT? → NO

YES

S11 — IS RECEPTION-
SIGNAL LEVEL
LOW? → NO → S13

YES

S12 — INCREASE GAIN
OF RF-AMP

S13 — DECREASE
GAIN OF
IF-AMP

S14 — IS SYNCHRONIZATION
ESTABLISHED?

YES

NO

S16 — DECREASE GAIN OF RF-AMP AND
INCREASE GAIN OF IF-AMP WHILE
MAINTAINING RECEPTION-SIGNAL
LEVEL AT CORRECT VALUE

S17 — IS SYNCHRONIZATION
ESTABLISHED? → NO

YES

S18 — IS GAIN OF
RF-AMP MINIMUM? → NO

YES

S15 — DETERMINE THAT DIGITAL
BROADCAST EXISTS IN
SET CHANNEL

S19 — DETERMINE THAT DIGITAL
BROADCAST DOES NOT
EXIST IN SET CHANNEL

RETURN

# FIG. 3

GAIN (dB)

$\gamma$; TOTAL GAIN OF FRONT END

$\beta$; GAIN OF IF-AMPLIFIER CIRCUIT

$\gamma = \alpha + \beta$

$\alpha$

$\alpha - \Delta$

$-\Delta$

$+\Delta$

$\beta$

$\beta + \Delta$

$\alpha$; GAIN OF RF-AMPLIFIER CIRCUIT

$\alpha(min)$; MINIMUM GAIN OF RF-AMPLIFIER CIRCUIT

REPETITIVELY PERFORM PROCESSING OF S16 → S17 → S18 → S16 → ··· AS SHOWN IN FLOWCHART OF FIG. 2

DETERMINE THAT DIGITAL BROADCAST DOES NOT EXIST IN SET CHANNEL AT S19

# FIG. 4

FROM STEP S10

S14

YES ← IS SYNCHRONIZATION ESTABLISHED?

NO

S21

IS GAIN-ADJUSTING-PROCESSING FLAG IN RADIO WAVEBAND FOR WHICH CHANNEL-SETTING COMMAND IS ISSUED "ON" ? → NO

YES

TO STEP S15

TO STEP S16

S22

DETERMINE THAT DIGITAL BROADCAST DOES NOT EXIT IN SET CHANNEL

RETURN